# EUROPÄISCHE PATENTSCHRIFT

(11) **EP 0 415 209 B1**
(45) Veröffentlichungstag und Bekanntmachung des Hinweises auf die Patenterteilung: **17.11.1994**
(21) Anmeldenummer: 90115842.8
(22) Anmeldetag: 18.08.1990
(51) Int. Cl.: H03G 3/20

(54) **Schaltungsanordnung zur Regelung des Pegels elektrischer Signale**
ABC circuit
Circuit CAG

(30) Priorität: 31.08.1989 DE 3928775
(43) Veröffentlichungstag der Anmeldung: 06.03.1991
(73) Patentinhaber: KE KOMMUNIKATIONS-ELEKTRONIK GMBH & CO, D-30179 Hannover (DE)
(72) Erfinder: Brahms, Martin, Dipl.-Ing., D-3000 Hannover 91 (DE); Hennig, Andreas, Dipl.-Ing., D-3008 Garbsen 4 (DE); Timmermann, Andreas, Dipl.-Ing., D-3003 Ronnenberg 1 (DE)
(74) Vertreter: Döring, Roger, Dipl.-Ing.

(56) Entgegenhaltungen:
- EP-A- 0 192 061
- US-A- 3 967 209
- US-A- 4 330 859

## Beschreibung

Die Erfindung bezieht sich auf eine Schaltungsanordnung zur Regelung des Pegels elektrischer Signale, mit der einem Eingang zugeführte Signale auf einen gleichbleibenden Pegel geregelt werden.

Eine derartige Schaltungsanordnung ist prinzipiell bei gebräuchlichen geregelten Verstärker vorhanden. Die Bezeichnung "Verstärker" wird dabei in der Fachwelt auch dann eingesetzt, wenn beispielsweise ein Strom nicht im eigentlichen Sinne verstärkt, also erhöht, wird, sondern auch dann, wenn für eine Regelung eine Verminderung des Stromes erforderlich ist. Der Einfachheit halber wird daher im folgenden statt des Wortes "Schaltungsanordnung" das kürzere Wort "Verstärker" verwendet. Der Einsatz eines Verstärkers ist bei der Übertragung analoger und digitaler Signale dann problemlos, wenn eine kontinuierliche Signalübertragung vorliegt. Ein zu hohes Eingangssignal kann beispielsweise durch eine Übersteuerung des Verstärkers verarbeitet werden. Probleme treten hingegen im sogenannten "Burstbetrieb" auf, bei dem die zu verarbeitenden Signale, die Bursts, in zum Teil großen Abständen vorliegen. Eine solche nicht kontinuierliche Signalübertragung ist beispielsweise bei der bidirektionalen Übertragung von Signalen im Zeitgetrenntlageverfahren gegeben. Mit den bisher bekannten Verstärkern ist eine einwandfreie Verarbeitung solcher Signale nicht möglich. Die Signale werden vielmehr verzerrt, weil die Bandbreite und der Dynamikbereich der bekannten Verstärker nicht ausreichen, um auch die in großen Abständen anfallenden Bursts in ein Ausgangssignal mit gleichbleibendem Pegel umzusetzen. Dieser Mangel der bekannten Verstärker kann dazu führen, daß an ihrem Ausgang kein brauchbares Signal zur Verfügung steht. Die Signalübertragung ist dann insgesamt nicht möglich.

Der Erfindung liegt die Aufgabe zugrunde, eine Schaltungsanordnung anzugeben, mit der der Pegel elektrischer Signale in einem weiten Frequenzbereich auch bei stark unterschiedlichen Pegeln verzerrungsfrei geregelt werden kann.

Diese Aufgabe wird mit einer Schaltunsanordnung der eingangs geschilderten Art gemäß der Erfindung dadurch gelöst,
- daß in Reihe mit einem ersten, an den Eingang angeschlossenen, einen ersten regelbaren Widerstand aufweisenden Verstärker, der bei niedrigem Pegel des am Eingang liegenden Signals mit maximaler Verstärkung arbeitet, ein zweiter Verstärker liegt, der einen zweiten regelbaren Widerstand und eine in Reihe mit demselben liegende stromgesteuerte Spannungsquelle mit zwei komplementären Ausgängen umfaßt,
- daß an die Ausgänge der Spannungsquelle ein Komparator und ein Regler mit zwei getrennten Ausgängen angeschlossen sind, von denen jeweils einer ein steuerndes Signal abgibt, Während gleichzeitig von dem anderen ein Sperrsignal ausgeht, und
- daß der eine Ausgang des Reglers mit dem ersten regelbaren Widerstand verbunden ist, während der andere Ausgang des Reglers an den zweiten regelbaren Widerstand angeschlossen ist.

Die so aufgebaute Schaltungsanordnung arbeitet rauscharm, da im kritischen Bereich mit niedrigem Pegel der Eingangssignale durch den ersten Verstärker eine stets maximale Verstärkung erfolgt. Sie garantiert außerdem eine breitbandige Arbeitsweise mit einem großen Dynamikbereich. Insgesamt ist eine verzerrungsfreie Verarbeitung der Eingangssignale sichergesellt. Das alles wird i.w. durch die Reihenschaltung der beiden Verstärker erreicht, die beide nacheinander durch den Regler verstellt werden. Ein schwaches Eingangssignal wird zunächst vom ersten Verstärker mit maximaler Verstärkung verstärkt. Wenn die Verstärkung nicht ausreicht, wird die weitere Regelung des Signalpegels durch den zweiten Verstärker übernommen. Bei einem starken Signal am Eingang, das durch die Schaltungsanordnung heruntergeregelt werden muß, ist die Reihenfolge umgekehrt.

Durch diese wohldefinierte Zuweisung der Pegelbereiche zum ersten Verstärker einerseits und zum zweiten Verstärker andererseits ist gewährleistet, daß zum einen bei geringem Eingangspegel die Eingangsstufe maximale Verstärkung hat (gutes Rauschverhalten) und zum anderen ein zu hoher Eingangspegel schon frühzeitig abgesenkt wird (Übersteuerungsfestigkeit).

Vorteilhafte Ausgestaltungen der Erfindung gehen aus den Unteransprüchen hervor.

Ausführungsbeispiele des Erfindungsgegenstandes sind in den Zeichnungen dargestellt.

Es zeigen:

Fig. 1 die Schaltungsanordnung nach der Erfindung in einer stark vereinfachten Darstellung.

Fig. 2 eine Einzeleinheit der Schaltungsanordnung.

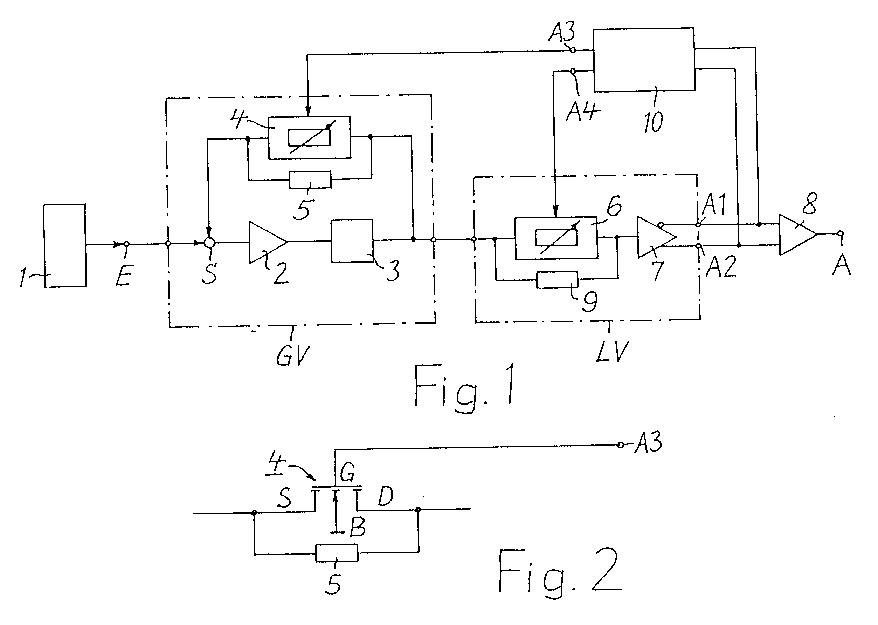

Die Schaltungsanordnung nach Fig. 1 arbeitet beispielsweise wie folgt:

Ein dem Eingang E von einer Signalquelle 1 aufgegebenes elektrisches Signal wird über einen Summierpunkt S einem Stromverstärker 2 zugeführt. Der Ausgangsstrom des Stromverstärkers 2 wird in einem Umsetzer 3 in eine umgekehrt proportionale Spannung umgesetzt. Diese Spannung wird über einen regelbaren Widerstand 4 zurück zum Summierpunkt S geführt. Parallel zum regelbaren Widerstand 4 liegt ein ohmscher Widerstand 5. Beide Widerstände 4 und 5 bilden zusammen ein Rückkopplungs-Netzwerk. Der Stromverstärker 2 verstärkt also einen Strom, der als Differenz der einerseits von der Signalquelle 1 und andererseits vom regelbaren Widerstand 4 kommenden Ströme am Summierpunkt S anliegt. Die Teile 2, 3, 4 und 5 stellen einen ersten, durch eine strichpunktierte Linie umrandeten, gegengekoppelten Verstärker GV dar, bei dem der Rückkopplungsfaktor in weiten Bereichen einstellbar ist (> 40 dB).

In Reihe mit dem ersten Verstärker GV liegt ein zweiter, ebenfalls von einer strichpunktierten Linie umrandeter Verstärker LV. Zu dem Verstärker LV gehören ein zweiter regelbarer Widerstand 6 und eine in Reihe mit demselben liegende, stromgesteuerte Spannungsquelle 7 mit zwei komplementären Ausgängen A1 und A2. Die beiden Ausgänge A1 und A2 der Spannungsquelle 7 sind an einen Komparator 8 angeschlossen, der das anliegende geregelte Signal durch Amplitudenentscheidung digitalisiert und als digitales Signal am Ausgang A zur Verfügung stellt. Parallel zum regelbaren Widerstand 6 liegt ein ohmscher Widerstand 9.

Das Ausgangssignal der Spannungsquelle 7 wird an den Ausgängen A1 und A2 symmetrisch abgegriffen und einem Regler 10 zugeführt, der zwei in bevorzugter Ausführungsform inverse Ausgänge A3 und A4 hat. An diesen Ausgängen stehen dann Spannungen zur Verfügung, die betragsmäßig gleich sind, aber entgegengesetzte Vorzeichen haben. Über den Ausgang A3 wird der regelbare Widerstand 4 beeinflußt, während der Ausgang A4 den regelbaren Widerstand 6 steuert.

Die Ausgänge A3 und A4 des Reglers 10 müssen nicht invers ausgeführt sein. Es muß nur sichergestellt sein, daß der eine Ausgang ein Sperrsignal liefert, so daß der angeschlossene Widerstand nicht beeinflußt wird, wenn der andere Ausgang ein steuerndes Signal abgibt. Das kann beispielsweise dadurch erreicht werden, daß der Ausgang, von dem ein Sperrsignal ausgeht, an Masse gelegt wird.

Es sei angenommen, daß von der Signalquelle 1 ein starkes Signal geliefert wird, das an den Ausgängen A1 und A2 der Spannungsquelle 7 zu einem zu hohen Pegel führt. Das zu hohe Ausgangssignal der Spannungsquelle 7 wird dem Regler 10, bei dem es sich beispielsweise um einen I-Regler handelt, zugeführt, der über seinen Ausgang A4 den regelbaren Widerstand 6 verstellt. Die beispielsweise positive Spannung am Ausgang A4 wird dazu vom Regler 10 verringert, so daß der Widerstandswert des Widerstandes 6 erhöht wird. Gleichzeitig bleibt die Spannung am Ausgang A3 negativ oder an Masse, so daß von diesem Ausgang ein Sperrsignal ausgeht und der Widerstand 4 nicht verstellt wird. Insgesamt wird dadurch der Pegel an den Ausgangen A1 und A2 der Spannungsquelle 7 verringert.

Die Verringerung dieses Ausgangspegels durch den Widerstand 6 ist durch den parallelen Widerstand 9 begrenzt, damit die hohen Spektralanteile des Signals nicht hauptsächlich über unvermeidliche Längskapazitäten übertragen werden. Das hätte Signalverzerrungen zur Folge. Durch die Dynamikbegrenzung mittels des Widerstandes 9 ist daher durch den regelbaren Widerstand 6 allein die gewünschte Absenkung des Pegels an den Ausgängen A1 und A2 u.U. nicht erreichbar.

Gleichzeitig mit der Verminderung der positiven Spannung am Ausgang A4 des Reglers 10 wird (bei inversen Ausgängen A3 und A4) die negative Spannung an dessen Ausgang A3 betragsmäßig vermindert. Das reicht zunächst jedoch nicht aus, um den regelbaren Widerstand 4 zu verstellen. Erst wenn die Spannung am Ausgang A3 positiv wird, führt das zu einer Verstellung des Widerstandes 4. Die dann negative Spannung am Ausgang A4 des Reglers 10 hält - als Sperrsignal - den Widerstand 6 auf denn eingestellten Wert.

Wenn also keine Verringerung des Pegels an den Ausgängen A1 und A2 der Spannungsquelle 7 mit dem Widerstand 6 mehr möglich ist, dieser Pegel jedoch immer noch zu hoch ist, dann wird die weitere Abwärtsregelung über den regelbaren Widerstand 4 durchgeführt. Mit steigender positiver Spannung am Ausgang A3 des Reglers 10 wird der Widerstandswert des regelbaren Widerstandes 4 verkleinert, so daß die Differenz der Ströme am Summierpunkt S kleiner wird (die wirksame Gegenkopplung wird dann vergrößert). Dem Stromverstärker 2 wird also ein so weit verminderter Strom zugeführt, daß an den Ausgängen A1 und A2 der Spannungsquelle 7 der gewünschte stabile Pegel vorliegt.

Wenn von der Signalquelle 1 ein nur schwaches Signal geliefert wird, geschieht folgendes:

Der regelbare Widerstand 4 wird zunächst durch eine abfallende positive Spannung am Ausgang A4 des Reglers 10 in seinem Wert vergrößert. Der maximale Wert des Rückkopplungs-Netzwerkes 4/5 wird begrenzt durch den Widerstand 5. Um die Gesamtverstärkung weiter erhöhen zu können, wird die Steuerspannung am Ausgang A3 des Reglers 10 solange vermindert (A4 wird entsprechend erhöht), bis der regelbare Widerstand 6 auf einen Wert abgesunken ist, aus dem an den Ausgängen A1 und A2 der Spannungsquelle 7 der gewünschte Pegel resultiert.

Die regelbaren Widerstände 4 und 6 sind nicht lineare Bauelemente. Sie sind in Fig. 1 vereinfacht als Stellwiderstände dargestellt. In bevorzugter Ausführungsform sind die Widerstände 4 und 6 als Feldeffekttransistoren ausgebildet, an deren Steuerelektroden, den Gates, die beiden Ausgänge A3 bzw. A4 des Reglers 10 angeschlossen sind. In Fig. 2 ist ein solcher Feldeffekttransistor als regelbarer Widerstand 4 dargestellt. Es handelt sich hier um einen symmetrisch aufgebauten D-MOSFET, dessen Gateelektrode G mit dem Ausgang A3 des Reglers 10 verbunden ist. Der parallel angeschlossene Widerstand 5 ist mit den Elektroden Source S und Drain D verbunden. Die Substratelektrode B liegt an Masse. Eine gleiche Anordnung kann für den Widerstand 6 verwendet werden.

Die stromgesteuerte Spannungsquelle 7 ist beispielsweise ein Transimpedanzverstärker mit zwei symmetrischen Ausgängen A1 und A2 (Gegentaktausgänge).

## Patentansprüche

1. Schaltungsanordnung zur Regelung des Pegels elektrischer Signale, mit der einem Eingang zugeführte Signale auf einen gleichbleibenden Pegel geregelt werden, dadurch gekennzeichnet,
- daß in Reihe mit einem ersten, an den Eingang (E) angeschlossenen, einen ersten regelbaren Widerstand (4) aufweisenden Verstärker (GV), der bei niedrigem Pegel des am Eingang liegenden Signals mit maximaler Verstärkung arbeitet, ein zweiter Verstärker (LV) liegt, der einen zweiten regelbaren Widerstand (6) und eine in Reihe mit demselben liegende stromgesteuerte Spannungsquelle (7) mit zwei komplementären Ausgängen (A1,A2) umfaßt,
- daß an die Ausgänge (A1,A2) der Spannungsquelle (7) ein Komparator (8) und ein Regler (10) mit zwei getrennten Ausgängen (A3,A4) angeschlossen sind, von denen jeweils einer ein steuerndes Signal abgibt, während gleichzeitig von dem anderen ein Sperrsignal ausgeht, und
- daß der eine Ausgang (A3) des Reglers (10) mit dem ersten regelbaren Widerstand (4) verbunden ist, während der andere Ausgang (A4) des Reglers (10) an den zweiten regelbaren Widerstand (6) angeschlossen ist.

2. Schaltungsanordnung nach Anspruch 1, dadurch gekennzeichnet, daß parallel zu den regelbaren Widerständen (4,6) jeweils ein ohmscher Widerstand (5,9) liegt.

3. Schaltungsanordnung nach Anspruch 1 oder 2, dadurch gekennzeichnet, daß die regelbaren Widerstände (4,6) als Feldeffekttransistoren ausgebildet sind, mit deren Steuerelektroden jeweils einer der Ausgänge (A3,A4) des Reglers (10) verbunden ist.

4. Schaltungsanordnung nach einem der Ansprüche 1 bis 3, dadurch gekennzeichnet, daß als stromgesteuerte Spannungsquelle (7) ein Transimpedanzverstärker verwendet ist.

5. Schaltungsanordnung nach einem der Ansprüche 1 bis 4, dadurch gekennzeichnet, daß der Regler (10) zwei inverse Ausgänge (A3,A4) hat, deren Spannungswerte betragsmäßig jeweils gleich sind.

## Claims

1. Circuit arrangement for controlling the level of electric signals, by which signals fed to an input are controlled to a constant level, characterized
- in that there is connected in series with a first amplifier (GV), which is connected to the input (E), has a first rheostat (4) and operates with maximum gain when the signal at the input is at low level, a second amplifier (LV), which comprises a second rheostat (6) and a current-controlled voltage source (7) which is connected in series with the latter rheostat and has two complementary outputs (A1, A2),
- in that connected to the outputs (A1, A2) of the voltage source (7) are a comparator (8) and a controller (10) with two separate outputs (A3, A4), of which in each case one emits a controlling signal, while at the same time an inhibiting signal is sent out by the other, and
- in that the one output (A3) of the controller (10) is connected to the first rheostat (4), while the other output (A4) of the controller (10) is connected to the second rheostat (6).

2. Circuit arrangement according to Claim 1, characterized in that an ohmic resistance (5, 9) is in each case connected in parallel with the rheostats (4, 6).

3. Circuit arrangement according to Claim 1 or 2, characterized in that the rheostats (4, 6) are designed as field-effect transistors, to the control electrodes of which in each case one of the outputs (A3, A4) of the controller (10) is connected.

4. Circuit arrangement according to one of Claims 1 to 3, characterized in that a transimpedance amplifier is used as the current-controlled voltage source (7).

5. Circuit arrangement according to one of Claims 1 to 4, characterized in that the controller (10) has two inverse outputs (A3, A4), the voltage values of which are in each case equal in absolute terms.

## Revendications

1. Circuit de régulation du niveau de signaux électriques, avec lequel des signaux amenés à une entrée sont régulés à un niveau constant, caractérisé
- par le fait qu'en série avec un premier amplificateur (GV) qui est relié à l'entrée (E), présente une première résistance réglable (4) et travaille avec l'amplification maximale lors d'un niveau bas du signal existant à l'entrée, se trouve un second amplificateur (LV) qui comporte une seconde résistance réglable (6) et une source de tension (7), commandée en courant, montée en série avec cette résistance et présentant deux sorties complémentaires (A1,A2),
- qu'aux sorties (A1,A2) de la source de tension (7) sont reliés un comparateur (8) et un régulateur (10) avec deux sorties distinctes (A3,A4) dont respectivement l'une émet un signal d'asservissement tandis que, simultanément, un signal de verrouillage est émis par l'autre, et
- que la première sortie (A3) du régulateur (10) est reliée à la première résistance réglable (4) tandis que l'autre sortie (A4) du régulateur (10) est reliée à la seconde résistance réglable (6).

2. Circuit selon la revendication 1, caractérisé par le fait qu'une résistance ohmique (5, 9) est montée en parallèle avec chacune des résistances réglables (4, 6).

3. Circuit selon la revendication 1 ou 2, caractérisé par le fait que les résistances réglables (4, 6) sont conçues sous forme de transistors à effet de champ, avec l'une des gâchettes de chacun desquels chacune des sorties (A3,A4) du régulateur (10) est respectivement reliée.

4. Circuit selon l'une des revendications 1 à 3, caractérisé par le fait que comme source de tension (7) commandée par le courant, on emploie un amplificateur d'adaptation d'impédance.

5. Circuit selon l'une des revendications 1 à 4, caractérisé par le fait que le régulateur (10) possède deux sorties (A3,A4) de signe opposé dont les valeurs de la tension sont respectivement égales valeur absolue.
